# EUROPÄISCHE PATENTSCHRIFT

(11) **EP 2 769 604 B1**
(45) Veröffentlichungstag und Bekanntmachung des Hinweises auf die Patenterteilung: **27.11.2019**
(21) Anmeldenummer: 12778951.9
(22) Anmeldetag: 02.10.2012
(51) Int. Cl.: H05K 7/20

(54) **KÜHLKREISLAUF-ANORDNUNG, INSBESONDERE ZUR VERWENDUNG IN EINEM RECHENZENTRUM SOWIE REGELVERFAHREN DAFÜR**
COOLING CIRCUIT SYSTEM, ESPECIALLY FOR USE IN A COMPUTING CENTER AND CORRESPONDING CONTROL METHOD
AGENCEMENT DE CIRCUIT DE REFROIDISSEMENT, DESTINÉ EN PARTICULIER À UN CENTRE DE CALCUL, AINSI QUE PROCÉDÉ DE RÉGULATION ASSOCIÉ.

(30) Priorität: 21.10.2011 DE 102011122824; 21.10.2011 DE 102011054704; 15.08.2012 DE 102012107473
(43) Veröffentlichungstag der Anmeldung: 27.08.2014
(73) Patentinhaber: RITTAL GmbH & Co. KG, 35745 Herborn (DE)
(72) Erfinder: NICOLAI, Michael, 35466 Rabenau (DE); BECKER, Dieter, 35713 Eschenburg (DE); HEMANN, Dirk, 35753 Greifenstein (DE); DÖRRICH, Martin, 35756 Mittenaar (DE)
(74) Vertreter: Angerhausen, Christoph
(86) Internationale Anmeldenummer: PCT/EP2012/004129
(87) Internationale Veröffentlichungsnummer: WO 2013/056787

(56) Entgegenhaltungen:
- US-A- 5 467 609
- US-A1- 2002 055 329
- US-A1- 2004 065 097
- US-A1- 2005 075 065
- US-A1- 2006 168 975
- US-A1- 2006 176 648
- US-A1- 2008 055 846
- US-A1- 2011 146 964
- US-A1- 2011 151 765
- US-A1- 2011 207 391

## Beschreibung

Die Erfindung betrifft eine Kühlkreislauf-Anordnung, insbesondere zur Verwendung in einem Rechenzentrum, gemäß dem Oberbegriff des Anspruchs 1. Eine solche Kühlkreislauf-Anordnung ist aus der US 2011/146964 A1 bekannt.

Viele Organisationen oder Unternehmen bedienen sich eines eigenen Rechenzentrums, um ihre rechenintensiven Arbeitsgänge auszuführen. Rechenzentren aller Größenordnungen werden heutzutage individuell geplant, wobei zwangsläufig immer wiederkehrende Tätigkeiten für jedes neue Rechenzentrum wiederholt werden, was schon in der Planungsphase eigentlich unnötige Kosten verursacht. Um den Fertigungsaufwand vor Ort gering zu halten, werden Rechenzentren oder Teile von Rechenzentren nach Anwenderwünschen vorab aufgebaut und an den Bestimmungsort transportiert, so dass die Betriebsbereitschaft in relativ kurzer Zeit sichergestellt werden kann. Solche Rechenzentren werden auch als modulare Rechenzentren bezeichnet.

Rechenzentren umfassen in der Regel eine große Anzahl an Servern, Netzwerk- und Computerausrüstung, um je nach Bedarf Daten zu verarbeiten, zu speichern und auszutauschen. Typischerweise sind in einem Rechnerraum viele Server-Racks aufgebaut, in denen Server und zugehörige Ausrüstung untergebracht sind.

Je nach Größe des Rechenzentrums kann eine große Menge an elektrischer Energie erforderlich sein, um die Anlage zu betreiben. Üblicherweise wird eine relativ hohe Spannung eingespeist, die dann auf eine niedrigere Spannung hinuntertransformiert wird. Ein Netzwerk aus Verkabelung, Anschlüssen und Energieverteilungseinheiten wird verwendet, um die Energie mit der niedrigeren Spannung an zahlreiche bestimmte Komponenten im Rechenzentrum zu liefern. Die Komponenten erzeugen dabei Abwärme in erheblichem Umfang, die abgeführt werden muss, so dass eine Klimatisierung erforderlich ist.

Bewertungsmaßstab ist dabei die von dem ,The Green Grid' Konsortium definierte Power Usage Effectiveness (PUE), die das Verhältnis des Gesamtenergieverbrauchs eines Rechenzentrums zu der Energieaufnahme der Rechner darstellt. Werte unterhalb von 1.3 gelten als hoch effizient.

Ein weiteres Problem in einem Rechenzentrum ist der physikalische Schutz vor z. B. Feuer, Rauch, Wasser und anderen Gefahren, welche die Server im Rechenzentrum beeinträchtigen oder sogar mehr oder weniger zerstören können.

Die Menge an Rechenkapazität, die bei einem Rechenzentrum benötigt wird, kann sich schnell ändern, wenn sich das Geschäftsumfeld ändert. Oftmals besteht ein Bedarf an erhöhter Rechenkapazität an einem Ort, wobei vorhandene Komponenten bei der Erweiterungsplanung oft auf Wunsch des Kunden berücksichtigt werden müssen. Das Erweitern vorhandener Kapazität ist allerdings ressourcenintensiv und nimmt eine lange Zeit in Anspruch. Es müssen Kabel verlegt, Racks bestückt und Kühlsysteme aufgebaut werden. Zusätzliche Zeit vergeht damit, Inspektionen durchzuführen und Zertifizierungen einzuholen. Skalierbarkeit ist daher für den Kunden ein wichtiges Argument schon beim Neuaufbau eines Rechenzentrums.

Die Firma Silicon Graphics International Corp., Fremont, Kalifornien, USA, vertreibt ein modulares Rechenzentrum in Containerbauweise, bei dem bis zu vier Server-Racks zu einer Einheit zusammengefasst werden, wobei sich das Rechenzentrum auf bis zu 80 Racks skalieren lässt. Das Klimatisierungs- und Kühlsystem arbeitet durch Verwendung intelligenter Lüfter sowie eines dreistufigen Verdunstungskühlungssystems mit hoher Energieeffizienz.

Der Gedanke des modularen Rechenzentrums ist auch Gegenstand der WO 2011/038348 A1. Ein modulares Rechensystem für ein Rechenzentrum umfasst ein oder mehrere Rechenzentrumsmodule mit Serversystemen, die in Racks angeordnet sind. Ein zentrales Elektromodul versorgt die Rechenzentrumsmodule mit elektrischer Energie. Mit Luft arbeitende Kühlmodule sind individuell jedem Rechenzentrumsmodul zugeordnet und enthalten optional einen Lüfter. Die Klimatisierung verwendet vorgekühlte Luft, die in die Rechenzentrumsmodule eingeleitet wird. Es ist auch ein Brandschutzsystem enthalten, das das elektrische Modul im Fall eines Feuers abschottet. Die Module eines Systems können vorgefertigt werden, wobei funktionale Elemente und strukturelle Elemente enthalten sind. Diese können als Einheit transportiert und am gewünschten Ort schnell aufgestellt werden.

Bei allen bekannten Rechenzentren, auch bei modularen Rechenzentren, besteht der Nachteil der individuellen Planung insbesondere bei der Aufrüstung bestehender Rechenzentren, wobei Effizienzüberlegungen nur unzureichend eingehen können.

Die Server und Racks eines Rechenzentrums sind, ebenso wie die Technik der Infrastruktur, wie Strom und Klima, auf einem auf den Rohboden aufgeständerten zweiten Boden, insgesamt als Doppelboden bezeichnet, aufgebaut. Hauptziel bei der Klimatisierung eines Rechenzentrums ist gegenwärtig die gesicherte Kaltluftversorgung. Es werden dazu beispielsweise Umluftklimasysteme eingesetzt, die kalte Luft in den Raum zwischen den Böden einblasen, wobei diese Kaltluft zur Kühlung durch besonders ausgebildete Platten aus dem Doppelboden von den Servern angesaugt wird. Warme Abluft wird auf der Rückseite der Racks abgegeben und von den Umluftklimasystemen angesaugt, die wiederum diese kühlen und die gekühlte Luft im Kreislauf den Servern wieder durch den Doppelboden zuführen. Energieeffizienz spielt hierbei eine eher untergeordnete Rolle. Der Doppelboden nimmt oftmals auch die Installation der Stromversorgungs- und Netzwerksverkabelungen auf. Ein Doppelbodensystem ist beispielsweise in der WO 2009/109296 A1 beschrieben.

Die DE 20 2009 015 124 U1 beschreibt eine Anordnung zum Kühlen von elektrischen und elektronischen Bauteilen und Moduleinheiten in Geräteschränken, welche beispielsweise in einem Rechenzentrum angeordnet sind. Es kann vorgesehen sein, dass eine Kühleinheit mit Ventilatoren in einem Doppelboden unterhalb eines Racks angeordnet sind, wobei die Ventilatoren lufttechnisch voneinander getrennt sind. Jedem Ventilator ist dabei eine Einrichtung zur Verhinderung einer Rezirkulation zugeordnet, welche, bezogen auf die Luftströmungsrichtung, nach dem jeweiligen Ventilator angeordnet ist.

Es ist die Aufgabe der vorliegenden Erfindung, eine Kühlkreislauf-Anordnung zur Verfügung zu stellen, mit der die Klimatisierung auf Energieeffizienz optimiert werden kann und die einfach auf- und umzurüsten ist.

Diese Aufgabe wird durch eine Kühlkreislauf-Anordnung nach Anspruch 1 gelöst. Vorteilhafte Ausgestaltungen sind Gegenstand der jeweils rückbezogenen Unteransprüche.

Eine Kühlkreislauf-Anordnung gemäß der vorliegenden Erfindung zeichnet sich dadurch aus, dass zumindest ein Teil der elektronischen oder elektronischen Bauteile mit einem Lüfter ausgestattet ist und dass das Kühlsystem, dessen Komponenten ausschließlich im Doppelboden untergebracht sind, keine eigenen Lüfter, jedoch wenigstens einen Wärmetauscher umfasst, der in einem oder mehreren Doppelbodenelementen unterhalb mindestens eines Gestellrahmen oder in einem oder mehreren Doppelbodenelementen des Warmgangs untergebracht ist.

Die Verwendung von Gestellrahmen zum Unterbringen der zu kühlenden elektrischen oder elektronischen Einheiten, beispielsweise Server, hat den wesentlichen Vorteil, dass die Geräte- beziehungsweise Systemkennlinie, welche die gegenseitige Abhängigkeit von Volumenstrom und Druckerhöhung bei der Strömung durch das Gerät beziehungsweise System beschreibt, relativ flach bleibt, die Anordnung also einen vergleichsweise kleinen Strömungswiderstand zeigt. Dies macht es möglich, parallel geschaltete Lüfter in effizienter Weise zu verwenden und insbesondere die Lüfter mit geringer Leistung, also mit geringer Drehzahl, zu betreiben. Während der Volumenstrom sich proportional zur Drehzahl ändert, ändert sich der Leistungsbedarf des Lüfters proportional zur dritten Potenz der Drehzahl, so dass hier ein großes Potenzial für Leistungseinsparungen geschaffen wird. Dabei muss nicht zwingend jedem Gestellrahmen ein Lüfter zugeordnet sein. Ein Grundgedanke der Erfindung besteht darin, den Raum vor den Servern insgesamt kühl zu halten, so dass durch die Parallelschaltung der Lüfter im niedrigen Leistungsbereich gearbeitet werden kann.

Durch eine intelligente Anordnung der Komponenten, gegebenenfalls unterstützt durch Luftleitbleche oder dergleichen, wird unterstützend dafür gesorgt, dass die Druckverluste in der Anordnung minimal bleiben.

Die Unterbringung aller Komponenten des Kühlsystems im Doppelboden der Kühlkreislauf-Anordnung ermöglicht zudem, wie später noch erläutert wird, ein verbessertes Raumnutzungskonzept, bei dem das zu kühlende Luftvolumen relativ klein gehalten wird, so dass wiederum mit geringer Lüfterleistung gearbeitet werden kann. Das kleine Luftvolumen bietet außerdem Vorteile bei einer etwa notwendigen Entfeuchtung.

Eine konsequente Trennung von Warm- und Kaltluft, kombiniert mit einer intelligenten Regelung, sind für die Realisierung höchster Kühllasten und Effizienzen unabdingbare Grundvoraussetzung.

Dabei wird die Kühlkreislauf-Anordnung optimiert, wenn ein Wärmetauscher in einem oder mehreren Doppelbodenelementen derart schräg verlaufend angeordnet ist, dass eine quer verlaufende Kante des Wärmetauschers nah am Gestellrahmen und die gegenüberliegende quer verlaufende Kante nah am Rohboden positioniert ist. Dadurch steht mehr Platz für den Wärmetauscher zur Verfügung, was sich in höherer Leistung beziehungsweise niedrigerem Druckverlust niederschlägt.

Nach einer bevorzugten Ausgestaltung sind die Wärmetauscher Wasser-Wasser-Wärmetauscher. Durch die Unterbringung im Doppelboden ist eine Gefährdung des elektrischen Systems ausgeschlossen, selbst wenn ein Leck auftreten sollte.

Dabei ist vorteilhaft, wenn die Verrohrung für den wenigstens einen Wärmetauscher in Doppelbodenelementen des Warmganges untergebracht ist.

Von besonderem Nutzen ist es, wenn zumindest ein Teil der Doppelbodenelemente als Gestell mit Abdeckung ausgebildet sind, in dem eine oder mehrere Komponenten des Kühlsystems vorkonfektioniert sind. So kann zum Beispiel ein Lüfter vorab in einem Doppelbodenelement eingebaut sein, wobei die Abdeckung als Gitter ausgebildet ist.

Wenn das Kühlsystem mindestens einen Wärmetauscher aufweist, ist es vorteilhaft, die Wasservorlauftemperatur eines Wärmetauschers über seinem Taupunkt zu halten, um die Bildung von Kondensat zu vermeiden. Bei einer solchen Ausgestaltung können weitere Komponenten, wie eine Kondensatwanne, entfallen.

Da bei der Erfindung nur relativ kleine Luftvolumina umgewälzt werden, kann, falls es nötig ist, das Luftvolumen zu entfeuchten, die Vorlauftemperatur über eine relativ kurze Regelzeitdauer unter den Taupunkt abgesenkt werden. Wenn erforderlich, kann während der Regelzeitdauer der Luftvolumenstrom angepasst werden. Mit einer solchen Regelung kann auf aufwändige und wartungsintensive Be- und Entfeuchtungssysteme verzichtet werden, die die Energiebilanz nur belasten würden.

Die Regelung verarbeitet dabei Signale von Temperatur- und/oder Feuchtigkeitssensoren, die wie erforderlich in dem Raum des Rechenzentrums, der Gestellrahmen und des Doppelbodens angebracht sind.

Die Erfindung zeigt ihre Vorteile optimal, wenn sie in einem nach dem Baukastenprinzip definierten Rechenzentrum eingesetzt wird, das auf standardisierten Bausteinen beruht. Insbesondere umfasst ein derartiges Rechenzentrum mindestens
- wenigstens eine Serverzelle zur Aufnahme eines oder mehrerer Server, wobei jede Serverzelle aus Bausteinen aufgebaut ist, die einem ersten Satz von Bausteinen entnommen sind,
- wenigstens eine Versorgungszelle, der zumindest eine Serverzelle zugeordnet ist, der die Versorgungszelle Strom, Kühlung, Netzwerkanbindung und Sicherheitstechnik zur Verfügung stellt, wobei jede Versorgungszelle aus Bausteinen aufgebaut ist, die einem zweiten Satz von Bausteinen entnommen sind, und
- wenigstens eine Zentralzelle, welche der Anbindung von Stromzuleitungen, Telekommunikationsleitungen und Fluidleitungen aus der und in die Außenwelt dient und der zumindest eine Versorgungszelle zugeordnet ist, wobei jede Zentralzelle aus Bausteinen aufgebaut ist, die einem dritten Satz von Bausteinen entnommen sind,
wobei die Bausteine des ersten Satzes von Bausteinen so konfiguriert sind, dass jeder Baustein in eindeutiger Weise an einen vordefinierten Baustein aus dem ersten Satz von Bausteinen oder an einen vordefinierten Baustein aus dem zweiten Satz von Bausteinen zu koppeln ist, wobei die Bausteine des zweiten Satzes von Bausteinen so konfiguriert sind, dass jeder Baustein in eindeutiger Weise an einen vordefinierten Baustein aus dem ersten Satz von Bausteinen oder an einen vordefinierten Baustein aus dem zweiten Satz von Bausteinen oder an einen vordefinierten Baustein aus dem dritten Satz von Bausteinen zu koppeln ist, und wobei die Bausteine des dritten Satzes von Bausteinen so konfiguriert sind, dass jeder Baustein in eindeutiger Weise an einen vordefinierten Baustein aus dem dritten Satz von Bausteinen oder an einen vordefinierten Baustein aus dem zweiten Satz von Bausteinen zu koppeln ist.

Die Standardisierung gelingt dabei durch eine Vordefinition der Schnittstellen der Bausteine. Dabei wird sichergestellt, dass beispielsweise nur ganz bestimmte Bausteinkombinationen überhaupt realisiert werden können. Da mit einem in sich geschlossenen Baukastensystem gearbeitet wird, kann nicht nur eine Effizienzgarantie gegeben werden, auch ist eine Kostenvorhersage für die Energiekosten des Rechenzentrums möglich.

Durch das Konzept verschiedener Arten von Zellen, nämlich Zentralzelle, Versorgungszelle und Serverzelle, ist eine jeweils individuelle Skalierbarkeit der Bausteine möglich.

Dabei ist eine dreistufige Topologie vorgesehen, bei der eine oder mehrere Zentralzellen den Versorgungszellen übergeordnet sind und diese wiederum eine oder mehrere Serverzellen bedienen.

Auch ist es möglich, dass eine Versorgungszelle Bestandteil einer Serverzelle ist.

In einer Serverzelle wird im Wesentlichen die Rechenleistung erbracht. Außerdem werden die notwendigen Infrastruktur-Versorgungspfade vorgehalten, nämlich für Strom, Kühlung, Netzwerkanbindung und Sicherheitstechnik, die von den Versorgungszellen zur Verfügung gestellt werden. Über die Zentralzellen wird die Kommunikation mit der Außenwelt realisiert, also Stromeinspeisung, Kälteerzeugung, Telekommunikationsanbindung und dergleichen. Je nach Tier-Klassifikation kann eine oder können mehrere Zentralzellen vorgesehen werden.

Die vorliegende Erfindung stellt dabei im Wesentlichen den ersten Satz von Bausteinen zur Verfügung, der mindestens einen Gestellrahmen oder ein Rack, mindestens einen Doppelbodenabschnitt mit integriertem Klimagerät und mindestens einen teilgeschotteten Gang mit Doppelbodenabschnitt oder Doppelbodenabschnitten umfasst. Die Doppelbodenabschnitte werden bei der Erfindung konsequent zur Unterbringung von Komponenten, wie beispielsweise Klimatisierungsgeräten, genutzt, damit für diese kein Platzbedarf auf der Servernutzfläche verschwendet wird. Weitere Bausteine können im ersten Satz von Bausteinen enthalten sein.

Bei der Erfindung soll der Doppelbodenabschnitt bereits mit einem integrierten Klimagerät versehen sein, wobei die Einhausung weiter vorteilhaft so gestaltet sein kann, dass sie die gewünschte Luftführung unterstützt. Optimal ist dabei eine Luftführung mit minimalen Umlenkungen, um unerwünschte Druckverluste zu vermeiden.

Nach einer weiteren bevorzugten Ausgestaltung umfasst der zweite Satz von Bausteinen mindestens einen Energieabsicherungs-Baustein, mindestens einen Stromunterverteilungs-Baustein, mindestens einen Kälteverteilungs-Baustein und mindestens einen Sicherheitstechnik-Baustein. Durch die vordefinierten Schnittstellen der Bausteine ist sichergestellt, dass der zu der gewählten Konfiguration der Serverzellen passende Baustein hinsichtlich Leistung, Funktion und gegebenenfalls weiterer Parameter ausgewählt wird.

Der dritte Satz von Bausteinen umfasst nach einer vorteilhaften Ausführungsform der Erfindung mindestens einen Kälteerzeugungs-Baustein, mindestens einen Energieeinspeisungs-Baustein, mindestens einen Stromhauptverteilungs-Baustein und mindestens einen NetzwerkBaustein, der ein aktives oder passives Netzwerk unterstützen kann. Auch hier gilt, dass aufgrund vordefinierter Schnittstellen jeweils nur der zur Konfiguration der Versorgungszellen passende Baustein gewählt werden kann

Im Folgenden soll die Erfindung anhand der beigefügten Zeichnung näher erläutert werden. Dabei zeigt:
- Figur 1: ein Beispiel für eine Topologie eines Rechenzentrums, das nach dem Baukastenprinzip gemäß der vorliegenden Erfindung erstellt worden ist;
- Figur 2: eine schematische Darstellung von beispielhaften Bausteinen in einer Zentralzelle der Topologie;
- Figur 3: eine schematische Darstellung von beispielhaften Bausteinen einer Versorgungszelle und einer Serverzelle der Topologie;
- Figur 4: ein Beispiel einer Zelleneinheit einer Serverzelle in Seitenansicht;
- Figur 5: ein Beispiel einer Zelleneinheit einer Serverzelle mit zugeordneter Versorgungszelle in einer Ansicht von vorn;
- Figur 6: ein weiteres Beispiel einer Zelleneinheit einer Serverzelle mit zugeordneter Versorgungszelle;
- Figur 7a: ein erstes Beispiel einer Kühlkreislauf-Anordnung für zu klimatisierende Serverzellen an einem Kaltgang, die nicht zur Erfindung gehört;
- Figur 7b: ein zweites Beispiel einer Kühlkreislauf-Anordnung für zu klimatisierende Serverzellen, die nicht zur Erfindung gehört;
- Figur 8: ein Beispiel für Lüfter- und Geräte- beziehungsweise Systemkennlinien zum Feststellen der Luftleistung;
- Figur 9: ein erfindungsgemäßes Beispiel einer Kühlkreislauf-Anordnung ohne Lüfter im Doppelboden;
- Figur 10: ein Beispiel eines Layouts für ein in einem Container untergebrachten Rechenzentrum;
- Figur 11a, 11b: eine Schnittansicht und eine perspektivische Ansicht eines weiteren Beispiels eines Container-Rechenzentrums.

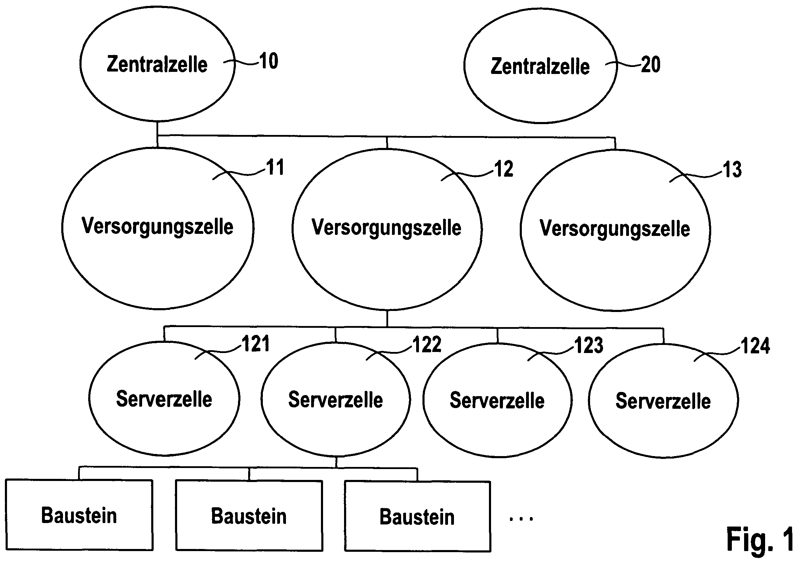

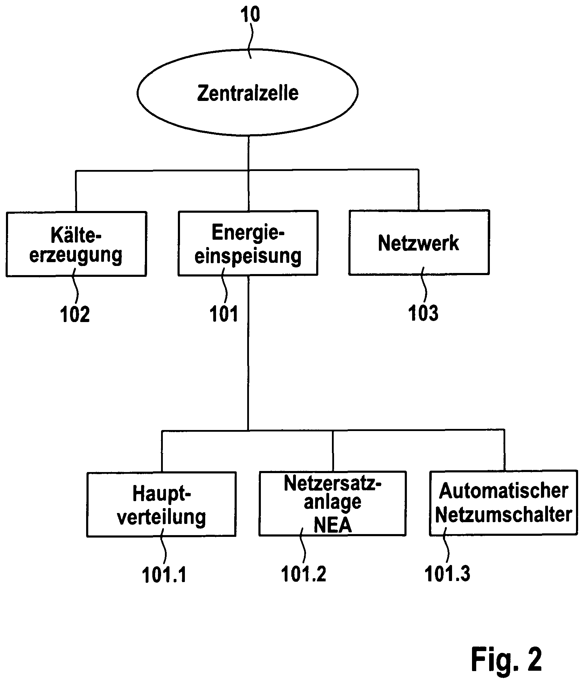

Figur 1 zeigt ein Beispiel für eine Topologie eines Rechenzentrums, das nach einem Baukastenprinzip erstellt wird und bei dem eine Kühlkreislauf-Anordnung gemäß der vorliegenden Erfindung verwendet werden soll. Die Topologie sieht dabei drei Ebenen vor, nämlich eine erste Ebene der Zentralzellen 10, 20, eine zweite Ebene der Versorgungszellen 11, 12, 13 und eine dritte Ebene der Serverzellen 121, 122, 123, 124. Wie es für die Serverzelle 122 angedeutet ist, ist dabei jede Zelle aus Bausteinen aufgebaut, wie im Folgenden noch näher erläutert wird. Bei der dargestellten Topologie sind beispielhaft zwei Zentralzellen 10, 20 vorgesehen, die genaue Anzahl der Zentralzellen richtet sich nach der angestrebten Tier-Klassifikation. Über derartige Zentralzellen 10, 20 wird die Kommunikation mit der Außenwelt realisiert. Dies betrifft Stromeinspeisung, Kälteerzeugung, Telekommunikationsanbindung und dergleichen. Bei der dargestellten Ausführungsform sind der Zentralzelle 10 drei Versorgungszellen 11, 12, 13 nachgeordnet. Der Zentralzelle 20 sind in der Regel ebenfalls Versorgungszellen nachgeordnet, die hier jedoch nicht veranschaulicht sind. Versorgungszellen stellen Stromabsicherung und Unterverteilung, die Kälteverteilung und Sicherheitstechnik für Serverzellen zur Verfügung. Dieses ist am Beispiel der Versorgungszelle 12 in schematischer Weise veranschaulicht, der vier Serverzellen 121, 122, 123, 124 nachgeordnet sind und die von ihr bedient werden. Entsprechend können die Versorgungszellen 11, 13 eine oder mehrere Serverzellen bedienen, was in der Figur jedoch nicht gezeigt ist. In einer Serverzelle, beispielsweise der Serverzelle 121, 122, 123, 124, wird im Wesentlichen die Rechenleistung des Rechenzentrums erbracht. Die notwendigen Infrastruktur-Versorgungspfade für Strom, Kühlung, Netzwerk, Sicherheit werden in jeder Serverzelle vorgehalten. Wie es beispielsweise an der Serverzelle 122 veranschaulicht ist, besteht diese aus einem oder mehreren Bausteinen. Auch Versorgungszellen, wie die Versorgungszellen 11, 12, 13, sind aus Bausteinen aufgebaut. Gleiches gilt für Zentralzellen, wie den Zentralzellen 10, 20. Dies ist in Figur 2 dargestellt.

Bausteine in einer Zentralzelle 10 sind im Wesentlichen die Energieeinspeisung 101, Kälteerzeugung 102 sowie Netzwerk 103. Die Energieeinspeisung 101 gliedert sich wiederum in Hauptverteilung 101.1, insbesondere Niederspannungshauptverteilung (NSHV), Netzersatzanlage (NEA) 101.2 und einen automatischen Umschalter 101.3 zur Auswahl verschiedener Energiequellen.

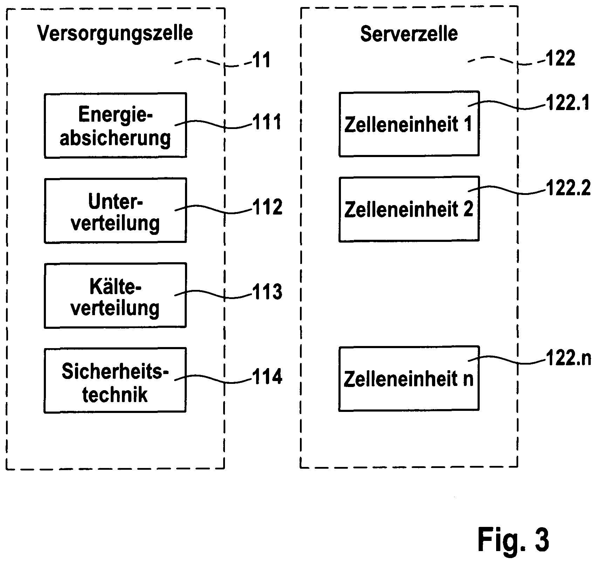

Wie in Figur 3 dargestellt, sind Bausteine einer Versorgungszelle 11 im Wesentlichen Energieabsicherung 111, Unterverteilung 112, Kälteverteilung 113 und Sicherheitstechnik 114, wie z. B. Fire-Safety. Die Energieabsicherung geschieht durch eine unterbrechungsfreie Stromversorgung (USV), die eingesetzt wird, um die Serverzellen bzw. Zelleneinheiten bei Störungen im Standardnetz mit Strom zu versorgen. Eine USV kann lokale Schwankungen und Ausfälle ausgleichen, indem sie angeschlossene Geräte mit elektrischer Energie aus Ackumulatoren speist, welche ständig aus dem Standardnetz nachgeladen werden. Der Baustein Unterverteilung 112 stellt dabei die Versorgung der Zelleneinheiten aus dem Standardnetz und aus dem USV-Netz sicher, wobei die Racks jeder Zelleneinheit sternförmig angefahren werden. Eine Serverzelle 121 besteht aus einer Zelleneinheit oder mehreren Zelleneinheiten, wie den Zelleneinheiten 122.1, 122.2, ... 122.n. Jede Zelleneinheit 122.1, 122.2, ... 122.n bildet einen Baustein einer Serverzelle 122 und ist selbst aus Bausteinen aufgebaut, nämlich aus einem oder mehreren Servergestellen, einem Gang oder Gangabschnitt, der auch teilgeschottet sein kann, sowie mindestens einer Doppelbodenplatte, die gegebenenfalls mit einem Klimagerät ausgestattet ist. Eine Versorgungszelle kann beispielsweise drei Zelleneinheiten einer Serverzelle bedienen.

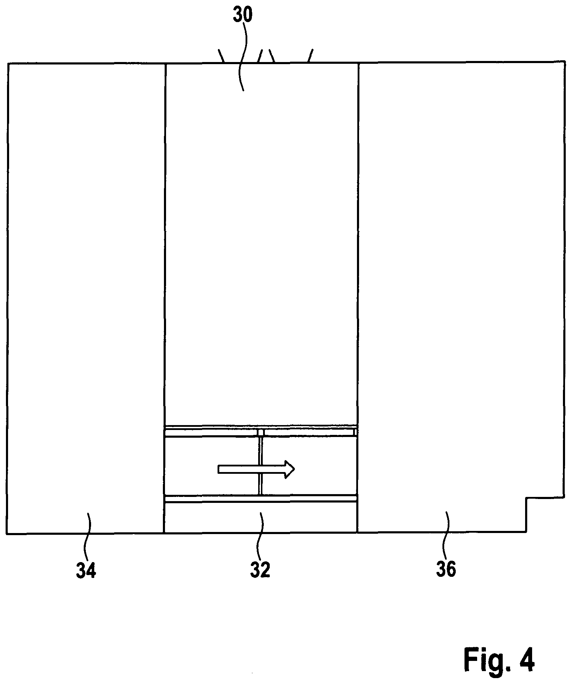

Figur 4 zeigt Beispiel einer Zelleneinheit einer Serverzelle in Seitenansicht. Zentraler Baustein der Zelleneinheit ist ein Gestellrahmen 30, der auf einem weiteren Baustein, einem Doppelbodenelement 32 mit Klimagerät, aufgestellt ist. Diese Anordnung ist seitlich begrenzt von einem dritten Baustein, bestehend aus einem (Warm)Gang 34 und Doppelbodenabschnitt und einem gegenüberstehend angeordneten Baustein, nämlich einem (Kalt)Gang 36 mit Doppelbodenabschnitt. Der Warmgang 34 und der Kaltgang 36 sind geschottet, so dass kühle Zuluft und warme Abluft strikt voneinander getrennt sind.

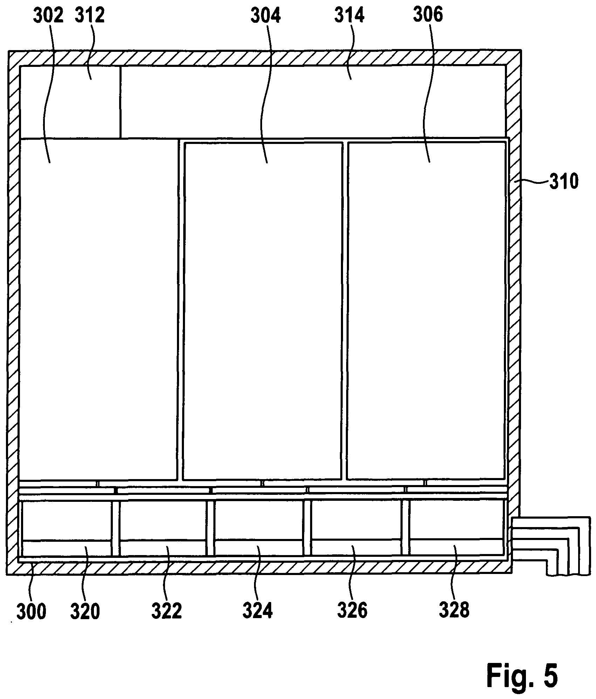

Figur 5 zeigt ein Beispiel einer Zelleneinheit einer Serverzelle mit zugeordneter Versorgungszelle in einer Ansicht von vorn. Die hier dargestellte Zelleneinheit besteht aus drei nebeneinander angeordneten Gestellrahmen 302, 304, 306, die auf Doppelbodenelementen 320, 322, 324, 326 und 328 auf einem Rohboden 300 aufgestellt sind. Ein Gestellrahmen dient zum Beispiel zur Aufnahme von zwei 19"-Ebenen zu je 47 Höheneinheiten (HE). Die Rasterung der Gestellrahmen 302, 304, 306 hat dabei ein größeres Rastermaß als die Rasterung der Doppelbodenelemente 320, 322, 324, 326, 328. Auf den Gestellrahmen 302, 304, 306 sind ein Stromverteilungsbaustein 312 sowie ein Netzwerkbaustein 314 angeordnet. Elektrik- und Elektronikkomponenten sind also getrennt deutlich oberhalb der möglicherweise Wasser führenden Klimageräte in den Doppelbodenelementen 320, 322, 324, 326, 328 angeordnet, so dass Leckagen-Problemen aufgrund austretenden Fluides weitgehend vorgebeugt wird. Die Zelleneinheit kann von einem weiteren Baustein, nämlich einer Schutzhülle 310 umgeben sein.

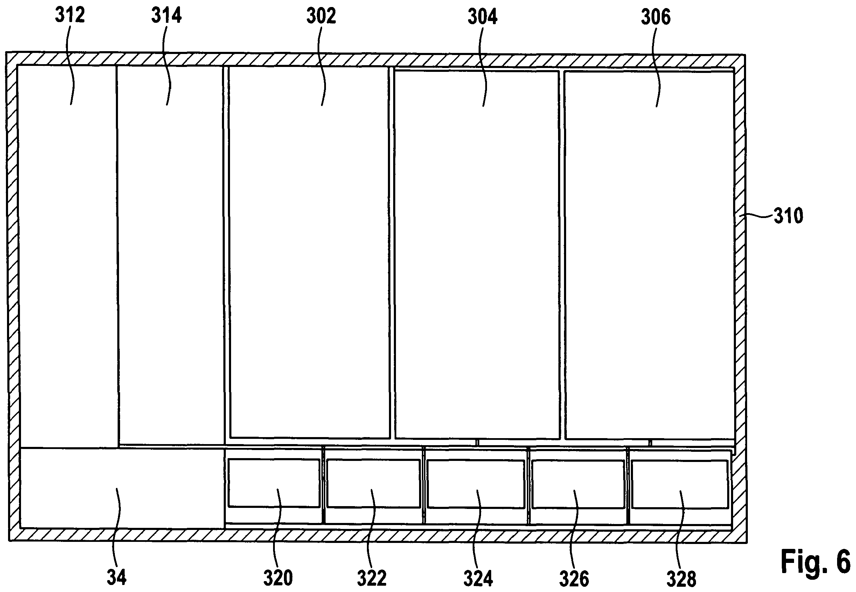

Figur 6 zeigt ein weiteres Beispiel einer Zelleneinheit einer Serverzelle mit integrierter Versorgungszelle. Die Zelleneinheit ist dabei, wie bei dem Beispiel der Figur 4, aus drei nebeneinander angeordneten Gestellrahmen 302, 304, 306 aufgebaut, die auf fünf Doppelbodenelementen 320, 322, 324, 326, 328 gestellt sind. Wieder kann ein Gestellrahmen entsprechend dem Beispiel der Figur 5 konfiguriert sein. Ein Doppelbodenelement oder mehrere Doppelbodenelemente können mit einem Klimagerät ausgestattet sein. Anders als bei dem Beispiel der Figur 4 ist der Baustein Stromverteilung 312, ebenso wie der Baustein Netzwerk 314 nicht oberhalb der Gestellrahmen 302, 304, 306 angeordnet, sondern neben dem Gestellrahmen 302, aber wiederum räumlich so von den Doppelbodenabschnitten 320, 322, 324, 326, 328 getrennt, dass Leckage-Probleme in diesen nicht auf die Elektrik- und Elektronikkomponenten durchschlagen können. Stromverteilung 312 und Netzwerk 314 schließen einen Gang 34 mit Doppelbodenabschnitt ab. Die Zelleneinheit kann von einem weiteren Baustein, nämlich einer Schutzhülle 310, umschlossen sein.

Einzelne Bausteine sollen im Folgenden beispielhaft anhand von Parametern und Funktionen beschrieben werden.

Ein Gestellrahmen oder Rack dient zur Aufnahme der Server und Speichersysteme und hat beispielsweise eine Kapazität von 2 x 42 HE, wobei Abmessungen wie z. B. von 2 x (600 x 2000 x 1000 mm³), aber auch andere Konfigurationen denkbar sind. Eine seitliche Schottung kann vorgesehen sein. Als Schnittstellen sind eine Stromanbindung, beispielsweise 30 kW, eine A&B-Versorgung (A: Standardnetz, B: USV-Netz) sowie Steckdosentöpfe vorhanden, die optional messbar und schaltbar sind. Die Steuerung der Klimatisierung erfolgt durch eine geeignete Elektronik und Software, wobei geeignete Führungsgrößen, wie Server-Zulufttemperatur oder Differenzdrücke, gewählt werden können.

Der Kühlung eines oder mehrerer, mit Servern bestückter Gestellrahmen dient ein in einem Doppelbodenelement vormontiertes Klimagerät, beispielsweise ein Wasser-Wasser-WärmeTauscher mit Pumpe. Dieser kann beispielsweise für eine Kühlleistung von 60 kW ausgelegt sein. Als Schnittstellen sind beispielsweise ein Kaltwasseranschluss mit 18 °C Vorlauftemperatur und ein Rücklaufanschluss für Warmwasser vorgesehen, weiter ein elektrischer Anschluss mit 1,8 kW. Die Steuerung geschieht durch Überwachen von Temperaturen, Drehzahlen und Durchflussmengen, geregelt werden dann Drehzahl und Durchflussmenge, um eine gewünschte Temperatur zu halten.

Die Klimatisierung bildet einen wesentlichen Bestandteil eines Rechenzentrums. Ein herkömmliches Rechenzentrum hat typischerweise eine Verteilung von Nutzfläche zu Supportfläche von etwa 60:40. Dieses Verhältnis wird wesentlichen bestimmt durch die im Rechenzentrum angeordneten Klimakomponenten, wie zum Beispiel CRAC-Einheiten oder LCP's (Liquid Cooler Packages) die neben oder zwischen den bestückten Gestellrahmen angeordnet sind und somit Fläche beanspruchen, die durch Server genutzt werden sollte. Durch konsequente Platzierung der benötigten Kühlkomponenten, wie Wärmetauscher, Be- und Entfeuchter, sofern nach der Erfindung überhaupt erforderlich, sowie Lüfter und Regelung in nicht durch mit Servern zu belegenden Bereichen, wie zum Beispiel dem Doppelboden, wird das bisher ungünstige Verhältnis deutlich zu Gunsten der Servernutzfläche verschoben und erreicht beispielweise ein Verhältnis 80:20. Be- und Entfeuchter sind dabei gegebenenfalls der Kälteerzeugung, also einer Zentralstelle, zugeordnet. Eine konsequente Trennung von Warm- und Kaltluft, kombiniert mit einer intelligenten Regelung, sind dabei für die Realisierung höchster Kühllasten und Effizienzen unabdingbare Grundvoraussetzung. Alle Komponenten sind dabei kompromisslos nach physikalischen Gesichtspunkten an der optimalen Stelle im Kühlkreis des Rechenzentrums angeordnet.

Ferner kann in einen Doppelbodenabschnitt ein Wärmetauscher integriert sein, der insbesondere geneigt verlaufend angeordnet ist, so dass das Volumen des Doppelbodenabschnitts zur Maximierung der Fläche des Wärmetauschers und somit dessen Kühlleistung genutzt wird. Der Druckverlust des Wärmetauschers ist aufgrund seiner Größe so niedrig, dass die in den Servern vorhandenen Lüfter in der Lage sind, diesen zusätzlichen luftseitigen Druckverlust zu überwinden, was mit höchster Energieeffizienz einhergeht, da kein zusätzlicher elektrischer Strom zum Betreiben separater Lüfter im Doppelboden erforderlich ist.

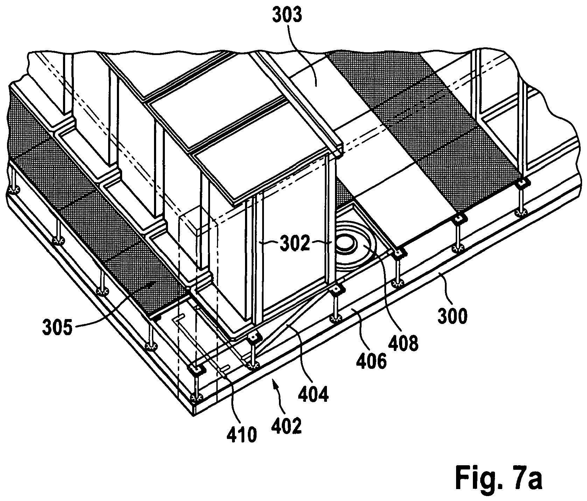

Figur 7a zeigt ein erstes Beispiel einer Kühlkreislauf-Anordnung für zu klimatisierende Serverzellen an einem Kaltgang, die nicht zur Erfindung gehört. Eine Serverzelle, bestehend aus beispielsweise sechs Gestellrahmen 302, die mit elektrischen oder elektronischen Komponenten, wie Servern und entsprechender Ausrüstung, bestückt sind, ist auf einem Doppelboden 300 mit Doppelbodenelementen 402, 406 aufgebaut. Gegebenenfalls kann dieser Serverzelle eine spiegelbildliche Version gegenüberstehen, so dass zwischen diesen ein geschotteter Kaltgang 303 gebildet wird. Aus dem Gestellrahmen 302 austretende Warmluft wird in ein Doppelbodenelement 402 geleitet, das einen vom Rohboden 300 bis nah an einen Gestellrahmen 302 schräg verlaufenden Wärmetauscher 404 sowie die dazugehörige Verrrohrung 410 enthält. Das Doppelbodenelement 402 ist dabei so angeordnet, dass der Wärmertauscher 404 sich unmittelbar unter der Serverzelle beziehungsweise dem Gestellrahmen 302 befindet. Dadurch wird ein zusätzlicher Schutz vor mechanischer Beschädigung von oben erzielt. Die Verrohrung 410 für den Wärmetauscher 404 befindet sich im Bereich des Warmgangs, der beispielsweise gegen eine Gebäudewand oder Containerwand abschließen kann. Die durch den Wärmetauscher 404 gekühlte Luft wird von einem in dem Doppelbodenelement 406 befindlichen Axiallüfter 408 in den Kaltgang 303 gefördert, und steht dann wieder zur Kühlung der elektrischen oder elektronischen Komponenten zur Verfügung. Der Kühlluftstrom verläuft also sozusagen "von vorn nach hinten" durch die Gestellrahmen 302.

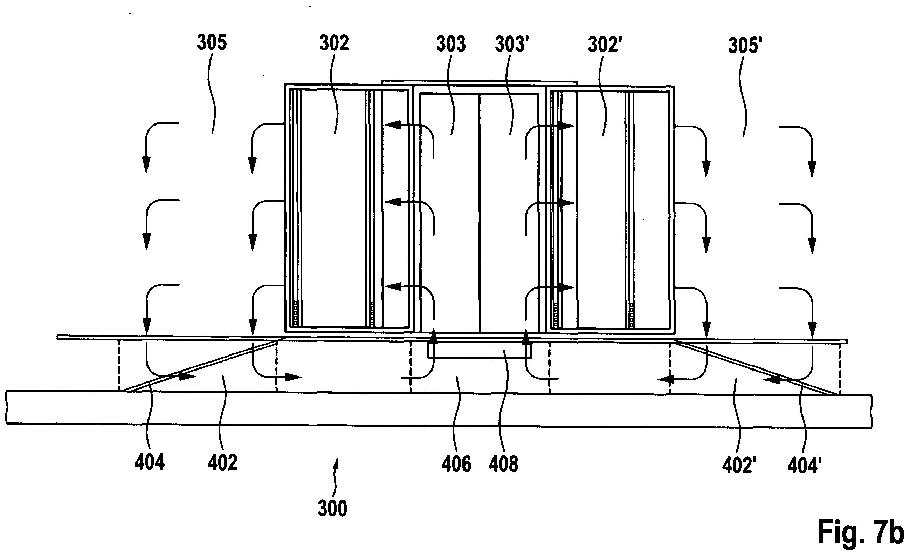

Ein weiteres Beispiel einer optimierten Kühlkreislauf-Anordnung, die nicht zur Erfindung gehört, ist in Figur 7b gezeigt. Eine Serverzelle, bestehend aus Gestellrahmen 302, die mit Servern und entsprechender Ausrüstung bestückt ist, ist auf einem Rohboden 300 aufgebaut, weiter ein geschotteter Kaltgang 303 als weiterer Baustein. Diesem steht eine spiegelbildliche Version mit Gestellrahmen 302' und geschottetem Kaltgang 303' gegenüber. Aus den Gestellrahmen 302 und 302' beziehungsweise den darin angeordneten Servern austretende Warmluft wird in ein jeweiliges Doppelbodenelement 402, 402' mit integriertem, schräg angeordneten Wärmetauscher 404, 404' geleitet, der sich bei dieser Ausführungsform im Bereich des Warmgangs 305, 305' befindet, die Warmluft abkühlt und innerhalb des Doppelbodens zu einem weiteren Doppelbodenelement 406 mit integriertem Axiallüfter 408 leitet, der nun wiederum gekühlte Luft in den Kaltgang 303, 303' einspeist.

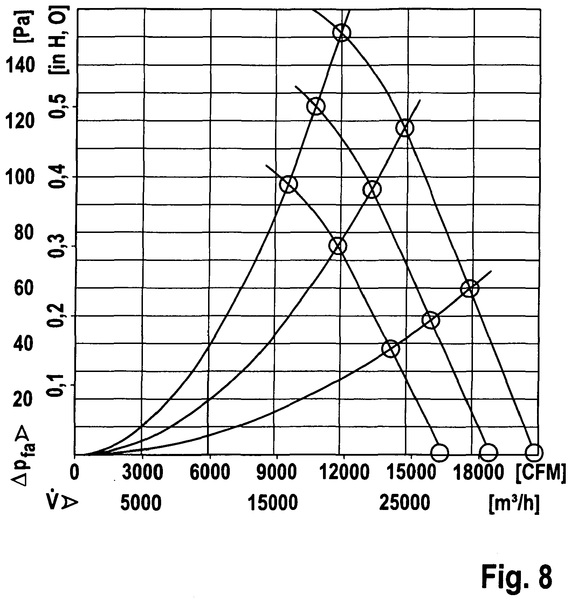

Figur 8 zeigt ein Beispiel für Lüfter- und Geräte- beziehungsweise Systemkennlinien zum Feststellen der Luftleistungen. Dabei ist auf der Abszisse der Volumenstrom, auf der Ordinate die Druckerhöhung aufgetragen. Die Lüfterkennlinien sind in Datenblättern angegeben, die vom Hersteller an einem Lüfterprüfstand gemessen werden. Je nach Einbausituation können die realen Kennlinien davon abweichen. In Figur 8 sind die Lüfterkennlinien für verschiedene Lüfter Leistungen mit A, B und C bezeichnet. Die Geräte- beziehungsweise Systemkennlinien D, E, F können durch numerische Simulation ermittelt werden. Der Betriebspunkt der Lüfteranordnung ergibt sich als Schnittpunkt von Lüfter- und Geräte- beziehungsweise Systemkennlinie. Im Betrieb erzeugt die Lüfteranordnung eine Druckerhöhung, die den Druckverlust im System genau kompensiert. Bei kleinerem Strömungswiderstand des Systems kann also mit dergleichen Lüfteranordnung ein wesentlich größerer Volumenstrom erzeugt werden, als bei einem System mit großem Strömungswiderstand. Durch die optimierte Luftstromführung bei der erfindungsgemäßen Kühlkreislauf-Anordnung lassen sich nun die Vorteile eines Lüfters im Parallelbetrieb ausnutzen. Da n parallel geschaltete (identische) Lüfter im Idealfall den n-fachen Volumenstrom erzeugen, kann bei niedrigen Drehzahlen gearbeitet werden, was sich günstig auf die Leistungsaufnahme der Lüfteranordnung auswirkt.

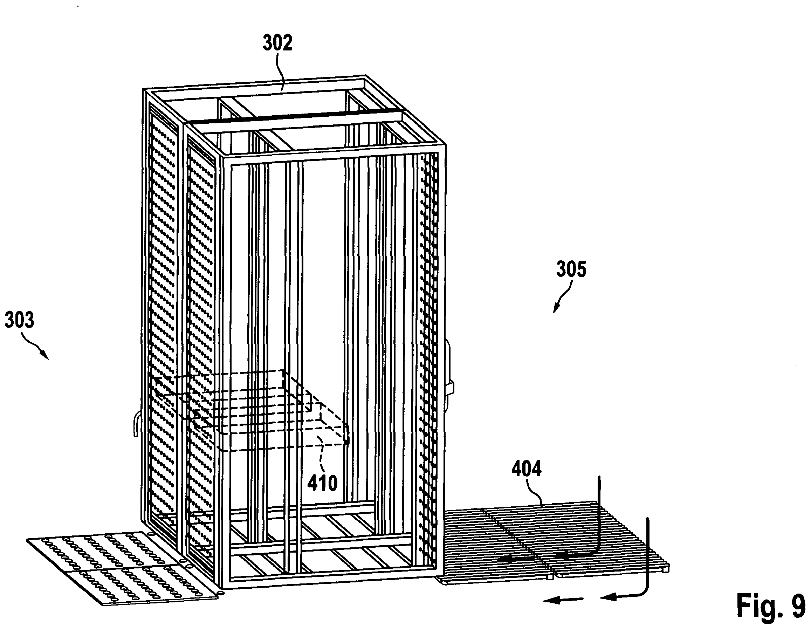

Die Standardisierung der Bausteine gemäß der vorliegenden Erfindung ermöglicht die Variante, dass der Ventilator eines Servers selbst für die erforderliche Luftführung sorgt. Diese Situation ist in Figur 9 schematisch veranschaulicht. In den Doppelbodenelementen des Kaltganges 303 befinden sich keine Lüfter, die Zirkulation besorgen hier ausschließlich Lüfter 410 von (nicht dargestellten) Serverkomponenten, die die Luft durch die Gestellrahmen 302 in den Warmgang 305 fördern, so dass sie vom Wärmetauscher 404 gekühlt werden kann. Auch Mischlösungen sind möglich, bei denen der Lufttransport sowohl von Lüftern im Doppelboden als auch von Lüftern 410 der Server besorgt wird.

Die Topologie eines Rechenzentrums gemäß der vorliegenden Erfindung kann in Software abgebildet werden. Software zur Effizienzbetrachtung steht zur Verfügung. Somit kann eine Planung standardisiert und automatisiert durchgeführt werden. Gleichzeitig ist eine Kostenplanung möglich, die nicht nur die Investitionskosten umfasst, sondern auch die laufenden Kosten, die sich aus der Effizienzbetrachtung ergeben.

Die einzelnen Bausteine können in ihren zulässigen Kombinationen vorab zertifiziert werden, so dass diesbezügliche Wartezeiten beim fertigen Rechenzentrum entfallen.

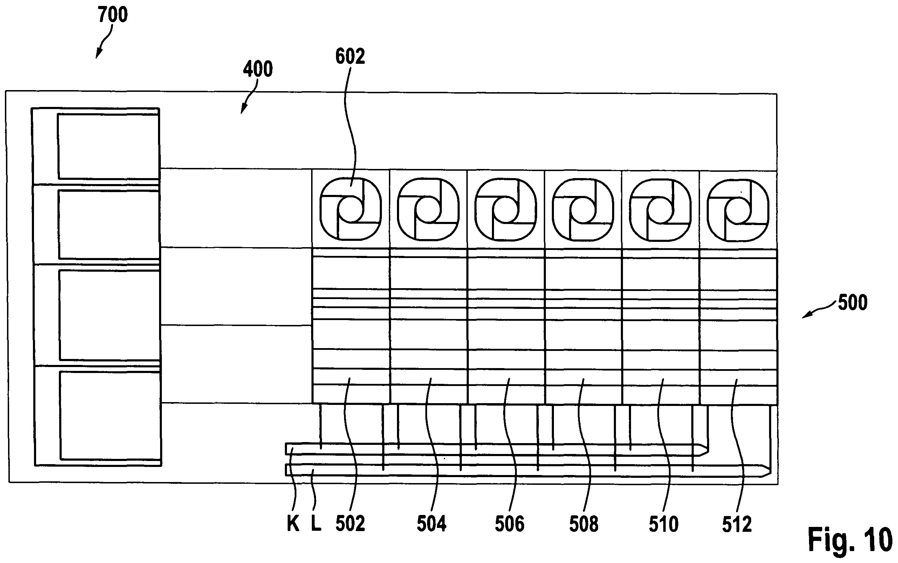

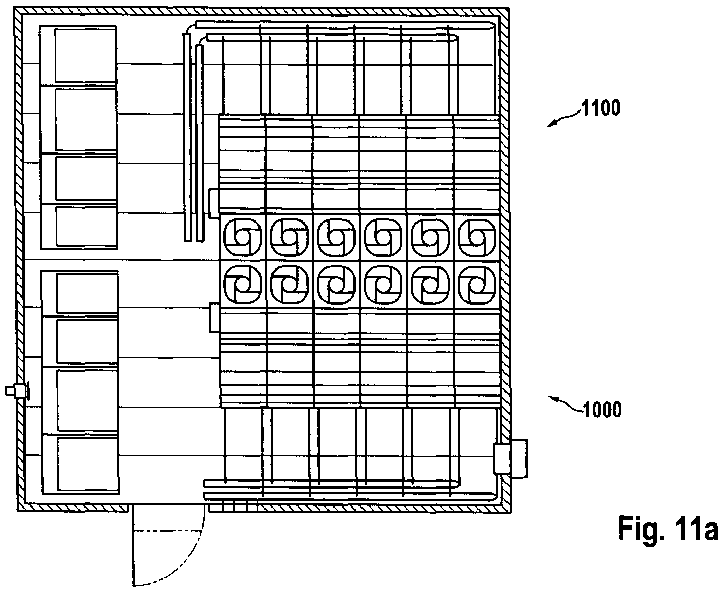

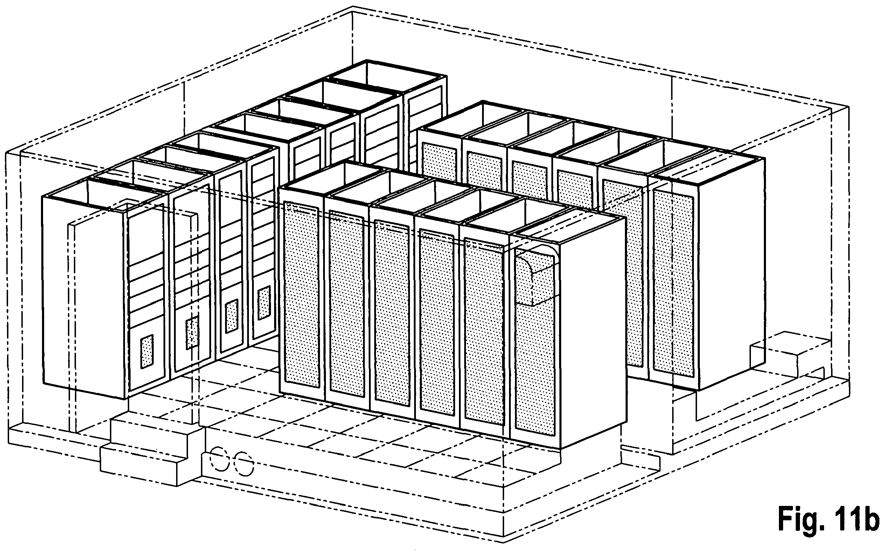

Die Erfindung ermöglicht damit in einfachster Weise den Neubau oder die Erweiterung von Rechenzentren durch Skalierung und/oder Austausch von vorhandenen Bausteinen gegen andere mit kompatibler Schnittstelle, aber höherer oder auch geringerer Leistung. Ein Rechenzentrum gemäß der vorliegenden Erfindung kann auch ganz oder teilweise in einem Container aufgebaut werden, ein beispielhaftes Layout dafür ist in der Figur 10 veranschaulicht. Sechs Zelleneinheiten 502, 504, 506, 508, 510, 512 einer Serverzelle 500 sind nebeneinanderstehend auf einem aus Doppelbodenabschnitten aufgebauten Doppelboden 400 angeordnet. Jeder der Zelleneinheiten, zum Beispiel 502, ist ein Doppelbodenabschnitt 602 mit integriertem Lüfter zugeordnet. Kaltwasserleitungen K und Warmwasserleitungen L sind ebenfalls im Doppelboden 400 geführt. Eine Zentralzelle und mehrere Versorgungszellen sind bei 700 untergebracht. Dabei müssen die Container nicht notwendigerweise im Wesentlichen geschlossen sein, ein größerer Rechnerraum kann durch eine Kombination zweier an einer Anschlussseite offener Container erhalten werden, wie es in Figur 11a in einer Schnittansicht und in Figur 11b in einer perspektivischen Ansicht gezeigt ist. Das Layout jedes Rechnerhalbraumes 1000, 1100 entspricht, abgesehen von der Leitungsführung, im Wesentlichen dem der Figur 10 beziehungsweise einem Spiegelbild davon.

Die Erfindung bietet somit durch seine klar definierte Anzahl geprüfter Bausteine und einer einfachen Definition, welche Bausteine wie kombinierbar sind, die Möglichkeit, flexibel nach Kundenwunsch ein Rechenzentrum aufzubauen.

## Patentansprüche

1. Kühlkreislauf-Anordnung, mit
- einer Anzahl nebeneinander angeordneter Gestellrahmen (30; 302, 304, 306), die einen Kaltgang (34; 303, 303') von einem Warmgang (36; 305, 305') trennt;
- einem aus Doppelbodenelementen (32; 320, 322, 324, 326, 328; 402, 406) auf einem Rohboden (300) aufgebauten Doppelboden, auf dem die Gestellrahmen (30; 302, 304, 306) aufgestellt sind;-zu kühlenden elektrischen oder elektronischen Bauteilen, die in den Gestellrahmen (30; 302, 304, 306) untergebracht sind; und
- einem Kühlsystem, dessen Komponenten im Doppelboden untergebracht sind,
**dadurch gekennzeichnet, dass** zumindest ein Teil der elektrischen oder elektronischen Bauteile mit einem Lüfter (410) ausgestattet ist; und
dass das Kühlsystem, dessen Komponenten ausschließlich im Doppelboden untergebracht sind, keine eigenen Lüfter, jedoch wenigstens einen Wärmetauscher (404) umfasst, der in einem oder in mehreren Doppelbodenelementen (32; 320, 322, 324, 326, 328; 402, 406) unterhalb mindestens eines Gestellrahmens (30; 302, 304, 306) oder in einem oder mehreren Doppelbodenelementen (32; 320, 322, 324, 326, 328; 402, 406) des Warmganges (305, 305') untergebracht ist.

2. Kühlkreislauf-Anordnung nach Anspruch 1, bei der ein Wärmetauscher (404, 404') in einem oder mehreren Doppelbodenelementen (32; 320, 322, 324, 326, 328; 402, 406) derart schräg verlaufend angeordnet ist, dass eine quer verlaufende Kante des Wärmetauschers nah am Gestellrahmen (30; 302, 304, 306) und die gegenüberliegende quer verlaufende Kante nah am Rohboden (300) positioniert ist.

3. Kühlkreislauf-Anordnung nach Anspruch 1, bei der die Wärmetauscher (404, 404') Wasser-Wasser-Wärmetauscher sind.

4. Kühlkreislauf-Anordnung nach Anspruch 1, bei der die Verrohrung für den wenigstens einen Wärmetauscher in Doppelbodenelementen (32; 320, 322, 324, 326, 328; 402, 406) des Warmganges untergebracht ist.

5. Kühlkreislauf-Anordnung nach Anspruch 1, bei der zumindest ein Teil der Doppelbodenelemente (32; 320, 322, 324, 326, 328; 402, 406) als Gestell mit Abdeckung ausgebildet ist, in dem eine oder mehrere Komponenten des Kühlsystems vorkonfektioniert sind.

## Claims

1. Cooling circuit arrangement, comprising
- a number of juxtaposed racks (30; 302, 304, 306) separating a cold aisle (34; 303, 303') from a hot aisle (36; 305, 305'),
- a double bottom consisting of double bottom elements (32; 320, 322, 324, 326, 328; 402, 406) mounted on a base bottom (300) on which double bottom the racks (30; 302, 304, 306) are mounted;
- electric or electronic components to be cooled, which components are accommodated in the racks (30; 302, 304, 306); and
- a cooling system comprising fans which is accommodated in the double bottom,
**characterized in that** at least a part of the electric or electronic components is equipped with a fan (410), and
that the cooling system, the components thereof being exclusively accommodated in the double bottom, does not include its own fans, but at least one heat exchanger (404) which is accommodated in one or multiple double bottom elements (32; 320, 322, 324, 326, 328; 402, 406) below at least one rack (30; 302, 304, 306) or in one or multiple double bottom elements (32; 320, 322, 324, 326, 328; 402, 406) of the hot aisle (305, 305').

2. The cooling system arrangement of claim 1, in which a heat exchanger (404, 404') is obliquely arranged in one or multiple of double bottom elements (32; 320, 322, 324, 326, 328; 402, 406) such that a transversely extending edge of the heat exchanger is positioned close to the rack (30; 302, 304, 306) and die opposite transversely extending edge is positioned close to the base bottom (300).

3. The cooling system arrangement of claim 1, in which the heat exchangers (404, 404') are water-water heat exchangers.

4. The cooling system arrangement of claim 1, in which the piping for the at least one heat exchanger is accommodated in double bottom elements (32; 320, 322, 324, 326, 328; 402, 406) of the hot aisle.

5. The cooling system arrangement of claim 1, in which at least part of the double bottom elements (32; 320, 322, 324, 326, 328; 402, 406) is designed as a covered frame in which one or a multiple components are pre-assembled.

## Revendications

1. Agencement de circuit de refroidissement, avec
- un certain nombre de baies (30 ; 302, 304, 306) disposées de façon juxtaposée qui séparent une allée froide (34 ; 303, 303') d'une allée chaude (36 ; 305, 305') ;
- un double fond qui est constitué d'éléments de double de fond (32 ; 320, 322, 324, 326, 328 ; 402, 406) sur un fond brut (300) et sur lequel les baies (30 ; 302, 304, 306) sont placées ; - des composants électriques ou électroniques à refroidir qui sont logés dans les baies (30 ; 302, 304, 306) ; et
- un système de refroidissement dont les composantes sont logées dans le double fond,
**caractérisé en ce qu'**au moins une partie des composants électriques ou électroniques est équipée d'un ventilateur (410) ; et
**en ce que** le système de refroidissement, dont les composantes sont logées exclusivement dans le double fond, ne comprend pas de ventilateur propre mais comprend au moins un échangeur de chaleur (404) qui est logé dans un ou dans plusieurs éléments de double de fond (32 ; 320, 322, 324, 326, 328 ; 402, 406) au-dessous d'au moins une baie (30 ; 302, 304, 306) ou dans un ou plusieurs éléments de double de fond (32 ; 320, 322, 324, 326, 328 ; 402, 406) de l'allée chaude (305, 305').

2. Agencement de circuit de refroidissement selon la revendication 1, dans lequel un échangeur de chaleur (404, 404') est disposé dans un ou plusieurs éléments de double de fond (32 ; 320, 322, 324, 326, 328 ; 402, 406) de façon oblique de sorte qu'une arête transversale de l'échangeur de chaleur est positionnée près de la baie (30 ; 302, 304, 306) et l'arête transversale opposée est positionnée près du fond brut (300).

3. Agencement de circuit de refroidissement selon la revendication 1, dans lequel les échangeurs de chaleur (404, 404') sont des échangeurs de chaleur eau-eau.

4. Agencement de circuit de refroidissement selon la revendication 1, dans lequel la tuyauterie pour l'au moins un échangeur de chaleur est logée dans des éléments de double de fond (32 ; 320, 322, 324, 326, 328 ; 402, 406) de l'allée chaude.

5. Agencement de circuit de refroidissement selon la revendication 1, dans lequel l'au moins une partie des éléments de double de fond (32 ; 320, 322, 324, 326, 328 ; 402, 406) est constituée en tant que bâti avec recouvrement dans lequel une ou plusieurs composantes du système de refroidissement sont préconfectionnées.
